(19)

**Europäisches Patentamt**
**European Patent Office**
**Office européen des brevets**

(11) **EP 3 248 019 B1**

(12) **EUROPÄISCHE PATENTSCHRIFT**

(45) Veröffentlichungstag und Bekanntmachung des Hinweises auf die Patenterteilung:
**13.03.2019 Patentblatt 2019/11**

(21) Anmeldenummer: **16700309.4**

(22) Anmeldetag: **11.01.2016**

(51) Int Cl.:
**G01R 15/20** *(2006.01)*    *G01R 33/00 (2006.01)*
**G01R 33/09** *(2006.01)*

(86) Internationale Anmeldenummer:
**PCT/EP2016/050389**

(87) Internationale Veröffentlichungsnummer:
**WO 2016/116315 (28.07.2016 Gazette 2016/30)**

(54) **MAGNETFELDSENSORVORRICHTUNG ZUR MESSUNG DES STROMES DURCH EINEN STROMFÜHRENDEN LEITER**

MAGNETIC FIELD SENSOR DEVICE FOR MEASURING THE CURRENT FLOWING THROUGH A CURRENT-CARRYING CONDUCTOR

DISPOSITIF DE DÉTECTION DE CHAMP MAGNÉTIQUE POUR LA MESURE DU COURANT À TRAVERS UN CONDUCTEUR PARCOURU PAR UN COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.01.2015 DE 102015100924**

(43) Veröffentlichungstag der Anmeldung:
**29.11.2017 Patentblatt 2017/48**

(73) Patentinhaber: **Sensitec GmbH**
**36633 Lahnau (DE)**

(72) Erfinder:
• **WEBER, Sebastian**
**35584 Wetzlar (DE)**

• **GLENSKE, Claudia**
**35638 Leun (DE)**
• **SCHMITT, Jochen**
**35216 Biedenkopf (DE)**
• **RÜHL, Jürgen**
**61203 Reichelsheim (DE)**

(74) Vertreter: **Spachmann, Holger**
**Stumpf Patentanwälte PartGmbB**
**Alte Weinsteige 73**
**70597 Stuttgart (DE)**

(56) Entgegenhaltungen:
**WO-A1-2010/009761**    **DD-A1- 255 214**
**JP-A- 2011 089 931**    **JP-A- 2012 150 007**
**US-A1- 2005 156 587**

EP 3 248 019 B1

**Beschreibung**

Die Erfindung betrifft eine Magnetfeldsensorvorrichtung zur Messung der Stärke eines Stromes durch einen oder mehrere Leiter auf Basis des den Leiter umgebenden Magnetfeldes. Insbesondere betrifft die Erfindung eine Magnetfeldsensorvorrichtung, die das Magnetfeld um einen einzelnen, oder eine Mehrzahl von stromdurchflossenen Leitern messen kann. In einem Nebenaspekt wird eine Strommesszange vorgeschlagen, die eine derartige Magnetfeldsensorvorrichtung umfasst.

STAND DER TECHNIK

Gattungsgemäße Magnetfeldsensorvorrichtungen zur Messung von Leiterströmen sind aus dem Stand der Technik hinlänglich bekannt. Sie erfassen eine um einen Leiter bzw. eine Mehrzahl von Leitern umgebende magnetische Feldstärke $H$ entlang einer geschlossenen Kurve $S$, wodurch ein Rückschluss auf den Gesamtstrom $I$, der durch die Fläche $A$, die durch die Kurve $S$ berandet wird, tritt, nach dem Ampèreschen Gesetz:

$$I = \iint\limits_{A} \vec{J} \cdot d\vec{A} = \oint\limits_{S} \vec{H} \cdot d\vec{s}$$

ermöglicht wird. Hierdurch ist eine berührungslose Stromerfassung ohne Eingriff in den Betrieb der elektrischen Schaltung möglich.

Zur Messung von Magnetfeldern ist bekannt, magnetoresistive Widerstände einzusetzen, die auf einem AMR-, GMR-, TMR oder XMR-Effekt beruhen. Derartige Widerstände weisen in der Regel eine magnetfeldsensitive Vorzugsrichtung bezüglich einer zu messenden Magnetfeldkomponente auf, in die eine hohe Widerstandsänderung bzw. Ausgangssignalwertänderung in Abhängigkeit des zu messenden Magnetfeldes erreichbar ist. Im Falle einer Strommessung ist eine hohe Widerstandsänderung tangential bzw. parallel zu einer geschlossenen, um den Leiter umlaufenden Kurve wünschenswert. Die materialspezifischen magnetoresistiven Effekte beruhen in der Regel auf dem Vorhandensein eines Stütz- oder Hilfsmagnetfeldes am Ort des magnetoresistiven Widerstandselements, dessen Stärke und Ausrichtung die Sensitivität und Lage der zu messenden Magnetfeldkomponente vorgibt. Beispielsweise erfordern AMR-Widerstände ein Hilfsfeld in einer Vormagnetisierungsschicht, das rechtwinklig zu einer zu messenden Magnetfeldkomponente ausgerichtet ist.

Die DE 10 2010 036 040 A1 beschreibt eine Magnetfeldsensorvorrichtung, wobei ein stromdurchflossener Leiter zur Führung des durch den Stromfluss hervorgerufenen Magnetfeldes von einem Ferritring umschlossen ist. Der Ferritring weist einen Luftspalt auf, in dem ein einzelner Magnetfeldsensor angeordnet ist. Der Ferritring kann durch ein hohes zu messendes Magnetfeld gesättigt werden, so dass keine Linearität von Magnetfeld- und Widerstandsänderung gegeben ist. Außerdem ist die Bandbreite der Strommessung durch den Ferritring begrenzt, sodass eine Bestimmung des messenden Stromes nur ungenau erfolgen kann.

In der DE 10 2008 030 334 A1 wird ein Hochstromsensor beschrieben, bei der eine Mehrzahl von MR-Sensoren, bevorzugt GMR-Sensoren um einen stromdurchflossenen Leiter angeordnet sind. Durch Verschaltung in Halb- oder Vollbrücken und durch die Hinzunahme einer Signalelektronik wird eine Strommessung realisiert. Zur Unterdrückung von externen Magnetfeldern, die durch Störströme hervorgerufen werden können, kann eine Vielzahl von Halb- oder Vollbrücken um den Stromleiter angeordnet werden und in der Signalverarbeitung eine numerische Korrektur von vorhandenen Störströmen erfolgen, was allerdings zusätzliche Aufwände beim Aufbau und der Signalauswertung nach sich zieht.

Aus der US 2005 0156587 geht eine Anordnung einer Mehrzahl kreisförmig um einen Leiter angeordneter Magnetfeldsensorelemente hervor, die einen Strom eines Leiters messen können. Hierbei weist eine Hälfte der Magnetfeldsensorelemente ein Ausgangssignalverhalten gegenüber einem zu messenden Stromes durch einen Leiter auf, das entgegengesetzt zu einer zweiten Hälfte der Magnetfeldsensorelement ist, um einen etwaigen DC-Gleichanteil bei der Signalauswertung des Stroms zu kompensieren. Hierzu ist eine geradzahlige Menge von Sensorelementen unabdingbar Bei Ausfall eines einzelnen Sensorelements würden sich gravierende Messfehler ergeben. Ein Stützfeld zur Homogenisierung des Sensorelementverhaltens ist aus keinen der genannten Druckschriften bekannt.

In der DD 255 214 A1 ist ein Verfahren und eine Vorrichtung zur berührungslosen Messung von Hochströmen bekannt, Die Vorrichtung weist eine Mehrzahl entlang einer geschlossenen Kurve um den Leiter angeordnete Magnetfeldsensorelemente auf, die eine magnetfeldsensitive Vorzugsrichtung im Wesentlichen tangential bzw. parallel zur Kurve auf. Des Weiteren ist eine Magnetfelderzeugungseinrichtung vorgesehen, die dem Kurvenverlauf folgende permanentmagnetische Magnetelement aufweisen, die am Ort der Magnetfeldsensorelemente ein magnetisches Hilfsfeld erzeugen, das zur Verstärkung oder Abschwächung des vom Leiter erzeugten Magnetfelds und somit zur Einstellung des Messbereichs dient und ebenfalls tangential bzw. parallel zur Kurve ausgerichtet ist. Somit dient das Hilfsmagnetfeld einer Skalierung des Messbereichs der Magnetfeldsensorelemente durch Verstärkung oder Abschwächung des zu messenden Magnetfelds. Die Magnetelemente sind voneinander beabstandet.

In der JP 2011 089931 A ist eine Magnetfeldsensorvorrichtung dargestellt, die zwei Magnetfeldsensorelement umfasst, die einen Strom einer Stromschiene messen sollen. Jedes Magnetfeldsensorelement weist eine magnetische Vorzugsrichtung auf, in der ein Sensorwert erfasst werden kann, und geometrische Ausrichtung der Brückenwiderstände. Jedem Magnetfeldsensorelement ist ein Permanentmagnet zugeordnet, der ein in Richtung des Leiters und somit rechtwinklig zu von diesem Leiter erzeugten Magnetfeld Bcur ein Hilfsfeld Bmag erzeugt. Die Überlagerung der Magnetfelder Bcur und Bmag ergeben den resultierenden Magnetfeldvektor B1/B2. Die Hilfsmagnetfelder Bmag dienen zur Sensitivitätseinstellung und zur Unterdrückung äußerer Magnetfelder.

In der JP 2012 150007 A ist eine Magnetfeldsensorvorrichtung, bei der zur Stabilisierung der Magnetisierung der dünnen Magnetschichten der Magnetfeldsensoren ein Hilfsmagnetfeld Hb eines Magneten eingesetzt werden soll, beschrieben. Alle Magnetfeldsensorelemente sind einem Hilfsfeld in dieselbe Richtung ausgesetzt, wobei das Hilfsmagnetfeld senkrecht zum zu messenden Feld Hex ausgerichtet ist.

Schließlich beschreibt die WO 2010/009761 A1 eine Magnetfeldsensorvorrichtung mit Magnetfeldsensorelementen mit einer magnetischen Vorzugsrichtung tangential zu einer geschlossenen Kurve um einen Leiter und parallel zu einem vom Leiter erzeugten Magnetfeld Hcur ausgerichtet ist, wobei eine Magnetspule ein Hilfsmagnetfeld Hbias erzeugt, das rechtwinklig zur Vorzugsrichtung ausgerichtet ist.

Aufgabe der Erfindung ist es, die Nachteile des vorgenannten Stands zu überwinden und eine universell verwendbare, kostengünstige und hochgenaue Magnetfeldsensorvorrichtung zur Strommessung bereitzustellen.

Diese Aufgabe wird durch eine Magnetfeldsensorvorrichtung nach dem unabhängigen Anspruch und durch eine Strommesszange umfassend eine derartige Magnetfeldsensorvorrichtung gelöst. Vorteilhafte Weiterbildungen sind in den nachfolgenden Unteransprüchen beschrieben.

OFFENBARUNG DER ERFINDUNG

Erfindungsgemäß wird eine Magnetfeldsensorvorrichtung zur Strommessung zumindest eines stromführenden Leiters vorgeschlagen, die eine Mehrzahl entlang einer geschlossenen, bevorzugt kreisförmigen, rechteckigen oder elliptischen Kurve um den Leiter angeordneter Magnetfeldsensorelemente, die eine magnetfeldsensitive Vorzugsrichtung im Wesentlichen tangential bzw. parallel zur Kurve aufweisen, umfasst. Es ist zumindest eine Magnetfelderzeugungseinrichtung vorgesehen, die ein magnetisches Hilfsfeld am Ort der Magnetfeldsensorelemente erzeugen kann. Erfindungsgemäß umfasst die Magnetfelderzeugungseinrichtung mehrere permanentmagnetische, dem Kurvenverlauf folgende und aneinanderstoßende Magnetelemente, die entgegengesetzt ausgerichtet sind, und die ein magnetisches Hilfsfeld am Ort der Magnetfeldsensorelemente erzeugen, das im Wesentlichen rechtwinklig zur magnetischen Vorzugsrichtung der Magnetfeldsensorelement ausgerichtet ist.

Das bzw. die Magnetelemente folgen dem Kurvenverlauf und bilden eine geschlossene Kurve aus. Dabei können einzelne Magnetelemente aneinanderstoßen und die Magnetelemente können derart ausgeformt sein, dass sie gekrümmt oder abgewinkelt sind, um dem Kurvenverlauf zu folgen. Die Magnetelemente erzeugen in der Anordnung ein homogenes Hilfsfeld, welches die Sensitivität der Magnetfeldsensorelemente gezielt einstellt. Hierdurch kann eine verbesserte Messgenauigkeit gegenüber der Verwendung von einzelnen lokalen Stützmagneten erreicht werden. Somit ist es möglich, auf den Einsatz von stromdurchflossenen Spulen zur Erzeugung eines Hilfsmagnetfeldes zu verzichten, die die Anordnung verteuern, und einer Regelung einer Stromquelle bedürfen. Der bzw. die als geschlossener Ring ausgeführte Aneinanderreihung von Magnetelementen kann fertigungstechnisch auf einer Trägerringscheibe der Gesamtanordnung angeordnet werden und ist vorteilhaft im Herstell- bzw. Montageverfahren für die Sensoranordnung integrierbar. Durch den Einsatz eines Hilfsmagnetfelds kann die Empfindlichkeit der Sensorvorrichtung justiert und eingestellt werden. Durch Einsatz von den, die gesamte Sensoranordnung umschließenden ringförmigen Stützmagneten oder Magnetsegmente als Magnetelemente kann sowohl die Homogenität und Stärke des Stützfeldes als auch die Abschirmung äußerer Störfelder im Vergleich zu einzelnen lokalen Stützmagneten an den Sensoren deutlich verbessert werden. Somit können toleranzbehaftete Änderungen des Ausgangssignalverhaltens einzelner Sensorelemente kompensiert werden. Der Stütz- und Abschirmmagnet kann als ein einteiliger, gleichförmig magnetisierter Ring ausgeformt oder aus gleich bzw. alternierend magnetisierten Segmenten aufgebaut sein. Aus gegenläufig magnetisierten Segmenten lässt sich besonders leicht eine Stromzange mit einem Öffnungsbereich zur Aufnahme eines Leiters bereitgestellt werden.

Somit ist die Magnetfelderzeugungseinrichtung eingerichtet, das magnetische Hilfsfeld am Ort jedes Magnetfeldsensorelements im Wesentlichen in einer magnetfeldsensitiven Ebene des Magnetfeldsensorelements rechtwinklig zu einer Magnetfeldkomponente des zu messenden stromführenden Leiters auszurichten. In der Regel ist das Magnetfeld um einen Leiter konzentrisch in einer geschlossenen Kurve um den Leiter herum ausgebildet, insbesondere bei runden Leitern ergibt sich ein Magnetfeld mit einem geschlossenem, in der Regel kreisförmigen Verlauf und mit Magnetfeldkomponenten, die tangential zu einer geschlossenen Kreiskurve um den Leiter ausgerichtet sind. Die Kurve, entlang der die Magnetfeldsensorelemente angeordnet sind, folgt günstiger Weise dem Verlauf des Magnetfelds des zu messenden Leiters. Rechtwinklig zu dem Magnetfeld des Leiters, insbesondere radial ausgerichtet zum Leiterschwerpunkt kann das Hilfsmagnetfeld ausgerichtet werden, um im Falle beispielsweise von AMR- oder GMR-Magnetfeldsensorelementen eine Stützwirkung und eine Abschirmwirkung gegenüber Störmagnetfeldern zu bewirken. Somit ist vorzugsweise das magnetische Hilfsfeld radial zum Leiter bzw. senkrecht zu dem Magnetfeld, das vom Leiter erzeugt wird, ausgerichtet, um die Sensitivität der Magnetfeldsensorelemente zu verbessern. Im Falle eines Flächenleiters, der einen räumlich ausgedehnten und evtl. von einer Kreisform abweichenden Querschnitt aufweist, z.B. einem Leiter mit elliptischem oder rechteckförmigem Leiterquerschnitt, kann die Kurve der Magnetfeldsensorelemente parallel zum Konturverlauf des Leiters verlaufen und das Hilfsmagnetfeld kann senkrecht zur Leiteroberfläche ausgerichtet sein.

In einer vorteilhaften Weiterentwicklung kann das permanentmagnetische Magnetelement ringförmig ausgebildet sein bzw. die permanentmagnetischen Magnetelemente, die direkt aneinanderstoßen oder zumindest dicht aneinander angeordnet sind, ringförmig ausgebildet sein. Herstellbedingt vorteilhaft kann an den Stoßstellen der Magnetelemente dünne Schichten nichtmagnetischen Materials, z.B. Folienmaterial, Kunststoffschichten etc. für einen Kantenschutz zwischen den aneinander stoßenden Flächen benachbarter Magnetelemente dazwischengeschoben angeordnet sein. In der Regel ist die Kurve bzw. der Ring aus Magnetelementen als runder Kreisring, elliptisch, rechteckig bzw. quadratisch um den Leiter angeordnet. Durch eine entsprechende Magnetisierung kann beispielsweise ein radiales ausgerichtetes Hilfsmagnetfeld erzeugt werden, was am Ort der einzelnen, ebenfalls ringförmig angeordneten Magnetfeldsensorelemente ein Stützfeld bewirkt, um beispielsweise im Falle eines AMR - Sensors eine erforderliche Vormagnetisierung zur Einstellung der magnetoresistiven Eigenschaften bereitstellen zu können. Die ringförmige Ausbildung der Magnetelemente folgt vorteilhafterweise konzentrisch der ringförmigen Anordnung der Magnetfeldsensorelemente. Der Ring aus Permanentmagneten ist in der Regel außerhalb des Rings, der von den Magnetfeldsensorelementen gebildet wird, angeordnet.

Vorteilhafterweise kann das Magnetelement bzw. die Anordnung von Magnetelementen den Kurvenverlauf der Magnetfeldsensorelemente umschließen. Dies bedeutet, dass der Ring des oder der Magnetelemente radial weiter entfernt vom Leiter als der Ring der Magnetfeldsensorelemente angeordnet ist. Dadurch kann eine räumliche Nähe der Magnetfeldsensorelemente zum Leiter erreicht und somit eine hohe Empfindlichkeit geschaffen werden. Das Hilfsmagnetfeld wirkt in das Innere der Kurve bzw. des Rings von Magnetfeldsensorelemente gerichtet, und durchsetzt bevorzugt in Richtung einer Normalen der Leiteroberfläche die Magnetfeldsensorelemente.

In einer vorteilhaften Weiterbildung kann die Magnetfelderzeugungseinrichtung eingerichtet sein, eine Magnetfeldkomponente des rechtwinklig zum Verlauf der Kurve ausgerichteten Hilfsmagnetfeldes, das am Ort einer ersten Teilmenge von Magnetfeldsensorelementen wirkt, relativ zum Leiter entgegengesetzt zu einer Magnetfeldkomponente des Hilfsmagnetfelds auszurichten, das am Ort einer zweiten Teilmenge von Magnetfeldsensorelementen auszurichten. Des Weiteren sind bevorzugt die Anzahl der Magnetfeldsensorelemente jeder Teilmengen identisch. Die Magnetfelderzeugungsvorrichtung erzeugt somit ein homogenes Magnetfeld, dass allerdings nicht gleichgerichtet für alle Magnetfeldsensorelemente relativ zum Leiter ausgerichtet ist, sondern erzeugt für eine erste Teilmenge von Magnetfeldsensorelementen ein Hilfsfeld in eine erste Richtung und für eine zweite Teilmenge der Magnetfeldsensorelemente ein Hilfsfeld in eine hierzu entgegengesetzte Richtung. Beispielsweise ist denkbar, ein für eine erste Teilmenge der Magnetfeldsensorelemente ein radial nach innen gerichtetes Hilfsfeld und für eine zweite Teilmenge von Magnetfeldsensorelementen ein radial nach außen gerichtetes Hilfsfeld vorzusehen. Erfindungsgemäß ist das Hilfsfeld, das von benachbart angeordneten Magnetelementen erzeugt wird, entgegengesetzt ausgerichtet. Somit sind Magnetfeldsensorelemente, die benachbarten Magnetelementen zugeordnet sind, entgegengesetzt gerichteten Hilfsmagnetfelder ausgesetzt. Sind benachbarte Magnetelemente gegensinnig orientiert, so ziehen sie sich magnetisch an, wodurch eine mechanisch stabilisierende Anordnung der aneinander angrenzenden Magnetelemente erreicht werden kann. Die Anzahl von Magnetfeldsensorelementen, die Hilfsmagnetfelder einer Ausrichtung bezüglich des Kurvenverlaufs bzw. bezüglich des stromführenden Leiters ausgesetzt sind, kann vorteilhafterweise gleich mit der Anzahl von Magnetfeldsensorelementen sein, die Hilfsmagnetfelder in die entgegengesetzte Richtung ausgesetzt sind. Die Ausrichtung der Hilfsmagnetfelder beeinflusst vorzugsweise das Signalwertverhalten bzgl. einer Stromänderung des

Leiters nicht. In einer vorteilhaften Weiterbildung können jedem Magnetelement ein oder mehrere Magnetfeldsensorelemente zugeordnet sein. Hierdurch kann das Hilfsmagnetfeld, das von einem Magnetelement erzeugt wird, einen einzigen oder mehreren Magnetfeldsensorelementen durchsetzen, so dass insbesondere eine Vielzahl von Magnetfeldsensorelementen von einem einzelnen Magnetelement erfasst vormagnetisiert werden kann. Die Anzahl der Magnetelemente kann reduziert werden, und mehrere Magnetfeldsensorelemente sind dem gleichen homogenen Hilfsmagnetfeld eines Magnetelements ausgesetzt.

In einer weiteren vorteilhaften Ausführungsform kann die Anzahl der Magnetelemente geradzahlig sein. Durch Vorsehen einer geradzahligen Menge von Magnetelementen können insbesondere bei abwechselnd gegensinnig orientierten benachbarten Magnetelementen sichergestellt werden, dass ein geschlossener Kreis von alternierend ausgerichteten Magnetelementen selbstanziehend geschlossen werden kann. Benachbarte Magnetelemente ziehen sich jeweils gegenseitig an, so dass ein stabiler geschlossener Kurvenverlauf der Magnetfelderzeugungseinrichtung erreicht werden kann.

In einer vorteilhaften Weiterbildung der Erfindung kann eine Kompensationsmagnetfelderzeugungseinrichtung umfasst sein, die ein magnetisches Kompensationsmagnetfeld am Ort jedes Magnetfeldsensorelements im Wesentlichen einer magnetfeldsensitiven Ebene des Magnetfeldsensorelements parallel und bevorzugt entgegengesetzt zu einer Magnetfeldkomponente des zu messenden stromführenden Leiters erzeugen kann. Die Kompensationsmagnetfelderzeugungseinrichtung hat die Aufgabe, am Ort des Magnetfeldsensorelements das vom stromführenden Leiter erzeugte Magnetfeld zu schwächen. Hierzu ist sie vorteilhaft derart ausgebildet, dass sie ein Kompensationsmagnetfeld erzeugen kann, welches Komponenten in der Empfindlichkeitsrichtung des Magnetfeldsensorelementes aufweist. Hierdurch können insbesondere bei hohen zu messenden Strömen der Sensitivitätsbereich der Magnetfeldsensorvorrichtung geändert und somit unterschiedliche Messbereiche erfasst werden. Die Regelung des Kompensationsstroms kann über eine geschlossene Regelschleife, z.B. einer Closed-Loop Regelung erfolgen, um das Wirkprinzip einer kompensierenden Messung oder Nullregelung zu realisieren. Damit ist das Ausgangssignal des Magnetfeldsensorelementes weitgehend unabhängig von Linearitätsfehlern und temperaturabhängigen Fehlern wie z.B. einer Offsetdrift.

In einer Weiterentwicklung der vorhergehenden Ausführungsform ist es vorteilhaft, dass das magnetische Kompensationsmagnetfeld jedes Magnetfeldsensorelements individuell einstellbar ist. Hierdurch kann jedem Magnetfeldsensorelement ein individuelles Kompensationsmagnetfeld überlagert werden. Insbesondere bei einem unsymmetrischen Magnetfeldverlauf, bei bauartbedingt verschiedenen messtechnischen Parametern der Magnetfeldsensorelemente oder zum Ausgleich von Effekten aufgrund von Montagetoleranzen kann das Kompensationsfeld neben der Realisierung der Nullpunktregelung ebenfalls dazu dienen, die magnetoresistiven Eigenschaften der Magnetfeldsensorelemente zu homogenisieren und Sensortoleranzen auszugleichen. Hierzu können einzelne Spulen für jedes Magnetfeldsensorelement vorgesehen sein, oder ein stromdurchflossene Leiterschicht ober- oder unterhalb jedes Magnetfeldsensorelements vorgesehen sein, das ein Kompensationsmagnetfeld erzeugen kann. Des Weiteren können bei Magnetfeldsensorelementen, die an verschiedenen Orten bezüglich des Leiters angeordnet sind, unterschiedliche starke Kompensationsmagnetfelder erzeugt werden, die auch relativ zum Sensorelement in verschiedene Richtungen ausgerichtet sein können. Die Art des Kompensationsmagnetfeldverlaufs kann ebenfalls an ein Charakteristikum des zu messenden Stromes angepasst werden, beispielsweise kann eine Frequenz und/oder Amplitude variiert werden um unerwünschte DC- bzw. AC-Anteile im Messsignal auszublenden.

Ist nach einer der vorgenannten Ausführungsformen eine Kompensationsmagnetfelderzeugungseinrichtung umfasst, so können weiterhin vorteilhaft eine Störsignalextraktionseinheit und eine Kompensationsstromerzeugungseinheit vorgesehen sein. Die Störsignalextraktionseinheit kann eingerichtet sein, aus zumindest einem Sensorsignal eines Magnetfeldsensorelements, insbesondere aus Sensorsignalen einer Mehrzahl oder aller Magnetfeldsensorelementen ein oder mehrere Störsignals zu extrahieren. Die Kompensationsstromerzeugungseinheit kann eingerichtet sein, aus dem extrahierten Störsignal ein Kompensationsstrom oder mehrere Kompensationsströme zur Erzeugung eines Kompensationsmagnetfelds an jedem Sensorelement für eine Unterdrückung des Störsignals zu erzeugen.

In diesem Zusammenhang wird unter einem Störsignal zum einen ein vom zum messenden Strom verursachten Sensorsignalanteil verstanden, der ein unerwünschtes Annähern des Sensorsignals an eine Sensoraussteuergrenze bewirkt. Hierunter fallen insbesondere DC-Stromanteile, die ein Offset des Sensorsignals in Richtung einer Aussteuergrenze bewirken. Ebenfalls können AC-Stromanteile des Sensorsignals als Störsignal gewertet werden, die die Magnetfeldsensorelemente in eine Aussteuergrenze führen. Zum anderen können Störsignale auch externe Ursachen haben, z.B. externe Magnetfeldanteile, die einen AC- oder DC-Verschiebung zumindest eines, einer Gruppe oder allen Magnetfeldsensorelemente bewirken. Auch diese Störsignalanteile können extrahiert und mittels einer Kompensationsstromregelung unterdrückt werden.

Die Störsignalextraktionseinheit erkennt zumindest aus einem Sensorsignal, insbesondere aus allen Sensorsignalen derartige Störsignalanteile. Die Störsignalextraktionseinheit gibt das bzw. die extrahierten Störsignale an eine Kompensationsstromerzeugungseinheit weiter, die einen Kompensationsstrom für alle Sensorelemente, oder individuell einstellbare Kompensationsströme für einen oder eine Gruppe von Sensorelementen erzeugen kann. Durch den bzw. die Kompensationsströme kann lokal an den Orten der Sensorelemente Kompensationsmagnetfelder erzeugt werden, um die Störmagnetfeldanteile zu unterdrücken. Störsignalextraktionseinheit und Kompensationsstromerzeugungseinheit bilden in Verbund mit der Kompensationsmagnetfelderzeugungseinrichtung und den Magnetfeldsensoren einen Regelkreis zur Unterdrückung von Störsignalen. Hierdurch wird ermöglicht, die Aussteuergrenze der Magnetfeldsensorvorrichtung auszudehnen und störsignalbereinigte Nutzsignale für eine nachgeschaltete Signalverarbeitung und -auswertung bereitzustellen. Störsignale werden auf Magnetfeldebene und nicht auf Signalverarbeitungsebene kompensiert, hierdurch ergeben sich ein vergrößerter Messbereich und eine verbesserte Signalqualität der Magnetfeldmessung. So können z.B. auf einen Versorgungsstrom aufmodellierte Datensignale störsicher mit hoher Qualität unabhängig von der Größe eines Versorgungsstroms extrahiert werden. Die Störsignalextraktion kann auf einer signaltheoretischen Verarbeitung und Analyse, einer Frequenzfilterung, einem Closed-Loop Regelkreis und bevorzugt einer PLL-Regelung beruhen.

Um unterschiedliche Messbereiche für die Strommessung realisieren zu können, können in einer vorteilhaften Weiterbildung der Erfindung zumindest zwei, bevorzugt formgleiche Kurvenanordnungen von Magnetfeldsensorelementen vorgesehen werden, die den stromführenden Leiter in unterschiedlichen radialen Abständen umschließen. So können konzentrische Kurvenanordnungen insbesondere konzentrische Kreis-, Ellipsen- oder Rechteckanordnungen von Magnetfeldsensorelementen um den stromführenden Leiter vorgesehen sein. Mit zunehmendem Abstand der Kurvenanordnungen vom Stromleiter nimmt die Amplitude des vom Stromleiter erzeugten und zu detektierenden Magnetfeldes ab, was zu einer unempfindlicheren Messung führt. Eine Verringerung des Abstandes der Magnetfeldsensorelemente an die Magnetfelderzeugungseinheit, führt aufgrund des damit verbundenen Erhöhung des Stützfeldes, da der Abstand zu den umgebenden Magnetelementen der Magnetfelderzeugungseinrichtung abnimmt, ebenfalls zu einer Abschwächung der Empfindlichkeit der Messeinheit. Somit lässt sich durch Auswahl von einer der zumindest zwei oder weiteren Kurvenanordnungen eine optimal an die Stromstärke angepasste Sensitivität erzielen.

In einer vorteilhaften Weiterbildung der Erfindung können die Magnetfeldsensor-elemente AMR-Magnetfeldsensorelemente oder GMR-Multilayer-Magnetfeldsensorelemente sein, die jeweils eine magnetfeldsensitive Vorzugsrichtung aufweisen. AMR- Sensorelemente weisen eine Sensitivitätsrichtung aus, die rechtwinklig zur eingeprägten Magnetisierungsrichtung im AMR-Element ist. Bei AMR-Magnetfeldsensorelementen wird eine innere Magnetisierung vorgegeben, die rechtwinklig zu einem äußeren, zu messenden Magnetfeld steht. In GMR-Multilagen-Sensoren dient das externe Stützfeld der Magnetfelderzeugungseinrichtung dazu, den Arbeitspunkt des Sensorelementes einzustellen. Durch das von der Magnetfelderzeugungseinrichtung erzeugte Hilfsmagnetfeld kann auch dazu dienen eine bereits im Magnetfeldsensorelement vorhandene innere Magnetisierung zu stabilisieren.

In einer vorteilhaften Ausführungsform kann die Magnetfelderzeugungseinrichtung von einer magnetischen Abschirmung umgeben sein. Die Abschirmung kann eine ringförmige Schicht aus ferromagnetischem Material umfassen, die zur Rückführung der Magnetfeldlinien des Hilfsmagnetfelds dient. Die Abschirmung kann äußere Magnetfelder unterdrücken, so dass diese geringen Einfluss auf die im Inneren umfassten Magnetfeldsensorelemente haben. Das Hilfsfeld kann geführt und fokussiert werden. Der Abschirmring kann Polstrukturen aufweisen, um die Magnetfeldführung des Hilfsmagnetfelds zu verbessern. Die Schirmwirkung kann durch Einsatz von Permanentmagnetmaterialien mit weichmagnetischem Anteil erreicht werden. Gegebenenfalls kann ein umlaufender Rückschluss ergänzt werden, der das Stützfeld im Inneren erhöht und das Streufeld im Außenbereich minimiert.

In einer vorteilhaften Weiterbildung der Erfindung kann die Anordnung der Magnetfeldsensorelemente und der Magnetfelderzeugungseinrichtung einen auftrennbaren Kurvenabschnitt zur Ein- und Ausführung des stromführenden Leiters, insbesondere einen auftrennbaren Kurvenabschnitt an einer Stoßstelle zweier entgegengesetzt magnetisierter Magnetelemente umfassen. Insbesondere bei der Anwendung als Strommesszange kann die Magnetfeldsensorvorrichtung zumindest an einer Stelle aufgetrennt werden, um den Leiter ohne Unterbrechung des Stromflusses in dem inneren Bereich des geschlossenen Kurvenverlaufs von Magnetfeldsensorelementen und Magnetfelderzeugungseinrichtung einzubringen. Hierbei können beispielsweise Magnetfeldsensorelemente und permanentmagnetische Magnetelemente auf einer Trägerringscheibe aufgebracht sein, wobei die Trägerringscheibe ein Schwenkgelenk aufweisen kann, so dass die Trägerringscheibe an einer Stelle auf- oder zuklappbar ist. Entgegengesetzt polarisierte Magnetelemente können an der Klappstelle aneinandergrenzen, um eine selbstschließende Haftwirkung zu erreichen, so dass nach Aufnahme des Leiters die Trägerringscheibe selbstschließend ausgebildet ist.

In einer vorteilhaften Weiterbildung kann jedes Magnetfeldsensorelement als Halbbrücke, als Vollbrücke in einer magnetoresistiven Wheatstone-Brückenschaltung verschaltet sein. Somit kann jedes Magnetfeldsensorelement nicht als einzelner magnetoresistiver Widerstand, sondern als beschaltete Halbbrücke oder Vollbrücke ausgebildet sein, und die einzelnen Halb- oder Vollbrücken der verschiedenen Magnetfeldsensorelemente können zur Signalauswertung zusammengeschaltet und signaltechnisch ausgewertet werden. Durch die Anordnung als Halb- oder Vollbrücke wird eine hohe Empfindlichkeit erreicht, so dass bereits kleine Magnetfelder gemessen werden können.

Vorteilhafterweise weisen Sensorausgangssignale aller Magnetfeldsensorelemente gegenüber einem von dem stromführenden Leiter erzeugten Magnetfeld eine gleichgerichtete Signalwertveränderung auf. Somit kann eine Erhöhung des Stromflusses durch eine Leiter eine Erhöhung eines Widerstandswertes bzw. eines Ausgangssignals aller Magnetfeldsensorelemente nach sich ziehen. Hierdurch ist eine unabhängige und parallele Verarbeitung der Ausgangssignale aller Magnetfeldsensorelemente möglich. Bei Ausfall einzelner Sensorelemente kann diese durch eine erhöhte Gewichtung der übrigen Ausgangswerte berücksichtigt werden. Auch kann durch Zu- oder Abschalten weiterer Magnetfeldsensorelemente, die beispielsweise auf Kurven verschiedener Abstände vom Leiter liegen, eine Fehlerkorrektur bzw. eine Erhöhung der Genauigkeit erreicht werden. Fertigungstechnisch können gleiche Sensorelemente eingesetzt werden, wodurch eine Toleranz der Messgenauigkeit reduziert und eine Genauigkeit der Vorrichtung erhöht wird.

In entsprechender Weise zur vorgenannten Ausführungsform, wobei die Ausgangssignale ein gleichartiges Verhalten gegenüber einer Stromänderung des Leiters aufweisen, können weiterhin vorteilhafterweise die Sensorausgangssignale aller Magnetfeldsensorelemente zur Bestimmung eines Stroms des stromführenden Leiters gewichtet, insbesondere gemittelt werden. Ein Gesamtstrom durch eine Leiteranordnung ergibt sich durch Summation über alle Sensorelemente einer gemessenen magnetischen Feldstärke jedes Sensorelements multipliziert einem hierzu zugeordneten Längsabschnitt einer geschlossenen Kurve, auf dem diese Feldstärke parallel zum Kurvenverlauf auftritt. Bei Ausfall einzelner Magnetfeldsensorelemente kann durch eine Mittelung bzw. Gewichtung entsprechend einem vergrößerten Längenabschnitt deren Ausfall kompensiert und weiterhin eine relativ genaue Messung erreicht werden. Der Ausfall eines Sensors von N-Sensoren führt lediglich zu einem Fehlmesswertbeitrag von 1/N, und kann bei einer Mittelung kompensiert bzw. bei Inkaufnahme einer erhöhten Messungsgenauigkeit toleriert werden. Somit kann eine getrennte Auswertung und Gewichtung bzw. Mittelung bei Detektion des Ausfalls einzelner Sensoren das Messergebnis dennoch genaue Werte liefern. Durch eine Mittelung insbesondere bei einer konzentrischen Anordnung der Sensorelemente um einen Leiter, wobei alle Sensorelemente im Idealfall denselben magnetischen Feldstärkenwert der vom Leiterstrom hervorgerufenen magnetischen Feldstärke messen, können Toleranzen und Störgrößen gegenseitig kompensiert und die Messgenauigkeit erhöht werden.

In einem Nebenaspekt der Erfindung wird eine Strommesszange vorgeschlagen, die eine Magnetfeldsensorvorrichtung nach einem der vorgenannten Ausführungsbeispiele umfasst. Somit kann eine aus dem Stand der Technik bekannte Strommesszange eine derartige Magnetfeldsensorvorrichtung umfassen, und die diesbezüglichen Vorteile erreichen.

In einer Strommesszange oder einem vergleichbaren Messgerät kann die Signalverarbeitung der Messsignale der Magnetsensorelemente erfolgen. Durch eine Signalverarbeitung der Magnetfeldsensorelemente, die als Vollbrücke, Halbbrücke oder Einzelwiderstände verschaltet werden können, kann durch die geometrische Position und die Größe der gemessenen Magnetfeldkomponente die Größe des Gesamtstroms ermittelt werden. Äußere Störfelder können durch Vergleich der Ausgangsgrößen aller Magnetfeldsensorelemente unterdrückt werden, da diese sich in erster Näherung als Gleichtaktkomponente in allen Sensorelementen auswirken. Zur Bildung des Messwertes können Ausgänge der Magnetfeldsensorelemente direkt miteinander verschaltet werden. Auch können diese über aktive Bauelemente, insbesondere Operationsverstärker miteinander verschaltet werde, um durch Summierung oder Differenzbildung das Messsignal zu erzeugen und homogene Störfelder zu unterdrücken. Ist eine Kompensationsmagnetfelderzeugungseinrichtung vorgesehen, so können durch die Auswertung der individuellen Kompensationsströme systematische Fehler, wie Linearitätsfehler oder Temperaturdriften minimiert werden. Weiterhin ist es auch möglich weitere Korrekturen der zu messenden Stromgröße durch Herausrechnen von weiteren Störgrößen vorzunehmen. So kann durch eine Auswertung der einzelnen Signalgrößen der Magnetfeldsensorelemente außerhalb der Anordnung erzeugte Störmagnetfelder erkennen und zusätzlich unterdrücken.

In der vorgeschlagenen Magnetfeldsensorvorrichtung wird ein homogenes magnetisches Hilfsfeld bereitgestellt, das eine gleiche, evtl. entgegengesetzte Ausrichtung und gleiche Stärke auf die Magnetfeldsensorelemente relativ zur zu messenden Magnetfeldkomponente des Stromleiters aufweist. Im Falle eines ungleich gewichteten Hilfsmagnetfelds kann eine Gewichtung der Sensorausgangsgrößen zur Kompensation von Asymmetrien vorgenommen werden, die durch ein Kalibrierungsverfahren ermittelt werden kann.

Zusätzlich zu Magnetelemente können stromdurchflossene Flipleiter zur Erzeugung des Hilfsmagnetfelds eingesetzt werden, die allerdings nachteilig bei der Abschirmung von Störfeldern sind, einen höheren Schaltungsaufwand bedürfen und zusätzlich elektrische Energie benötigen. Die Magnetfeldsensorelemente können in sich bereits eine permanentmagnetisierte Magnetschicht umfassen, um zumindest teilweise ein individuelles Hilfsmagnetfeld zu erzeugen, was durch das externe Hilfsfeld noch zusätzlich stabilisiert wird.

## ZEICHNUNGEN

Weitere Vorteile ergeben sich aus den vorliegenden Zeichnungsbeschreibungen. In den Zeichnungen sind erfindungsgemäße und nicht-erfindungsgemäße Ausführungsbeispiele dargestellt.

Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

Fig. 1a schematisch eine erste Ausführungsform einer nichterfindungsgemäßen Magnetfeldsensorvorrichtung;

Fig. 2 schematisch eine zweite Ausführungsform einer erfindungsgemäßen Magnetfeldsensorvorrichtung;

Fig. 3 Wheatstone-Messbrückenschaltungen zur Verschaltung einer erfindungsgemäßen Magnetfeldsensorvorrichtung;

Fig. 4 schematisch eine dritte Ausführungsform einer nichterfindungsgemäßen Magnetfeldsensorvorrichtung;

Fig. 5 schematisch eine weitere Ausführungsform einer erfindungsgemäßen Magnetfeldsensorvorrichtung;

**Fig. 6** schematisch eine weitere, auftrennbare Ausführungsform einer erfindungsgemäßen Magnetfeldsensorvorrichtung;

**Fig. 7** schematisch eine weitere Ausführungsform einer erfindungsgemäßen Magnetfeldsensorvorrichtung mit Kompensationsmagnetfelderzeugungseinrichtung;

**Fig. 8** schematisch eine Ausführungsform einer Kompensationsstromerzeugungseinheit zur Unterdrückung von Störsignalen;

**Fig. 9** schematisch weitere Ausführungsformen einer nichterfindungsgemäßen Magnetfeldsensorvorrichtung;

**Fig. 10** eine Ausführungsform einer erfindungsgemäßen Strommesszange mit Magnetfeldsensorvorrichtung.

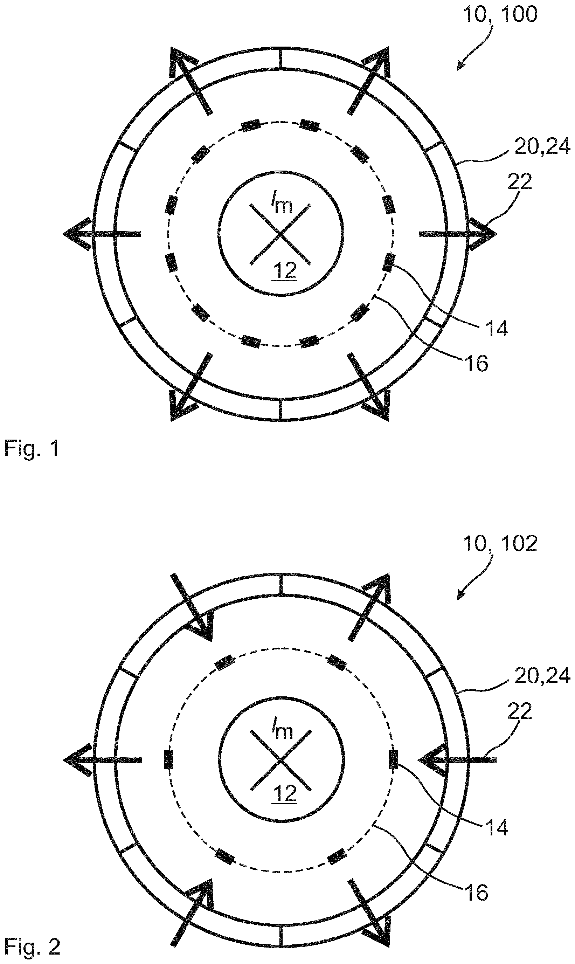

In den Figuren sind gleichartige Elemente mit gleichen Bezugszeichen beziffert. In der Fig. 1 ist schematisch ein erstes Ausführungsbeispiel 100 einer Magnetfeldsensorvorrichtung 10 dargestellt. Die Magnetfeldsensorvorrichtung 100 ist kreisscheibenförmig aufgebaut und umfasst eine innere Öffnung, in der ein stromführender Leiter 12 mit einem zu messenden Strom $I_m$ durchgeführt werden kann. Ringförmig um die Öffnung des stromführenden Leiters 12 sind Magnetfeldsensorelemente 14 entlang einer Kreiskurve 16 aneinandergereiht. In diesem Ausführungsbeispiel 100 sind auf dem Kreisring 16 zwölf Magnetfeldsensorelemente 14 aneinandergereiht. Radial beanstandet wird der Kreisring der Magnetfeldsensorelemente 14 von einer Magnetfelderzeugungseinrichtung 20 umgeben, die aus aneinanderstoßenden einzelnen Permanentmagneten 24 besteht, welche gleichsinnig radial orientiert magnetisiert sind und ein magnetisches Hilfsfeld 22 erzeugen. Das magnetische Hilfsfeld 22 ist radial nach außen gerichtet, so dass im Inneren ein Nord- und im Äußeren radial nach außen gerichtet ein Südpol erzeugt wird, und sich die magnetischen Feldlinien abseits der Ringscheibenebene, auf dem sich die Magnetfeldsensorelemente 14 befinden, schließen. Das magnetische Hilfsfeld 22 bewirkt im Bereich der Magnetfeldsensorelemente 14 ein magnetisches Stützfeld, durch das beispielsweise AMR-Magnetfeldsensorelemente in radialer Richtung gestützt werden. Das magnetische Feld, das von einem zu messenden Strom $I_m$ eines stromführenden Leiters 12 erzeugt wird, ist ebenfalls kreisringförmig parallel zu der Kurve 16 der Magnetfeldsensorelemente 14 ausgerichtet und steht somit rechtwinklig auf dem magnetischen Hilfsfeld 22. Das magnetische Hilfsfeld 22 dient dazu, die Sensitivität der Magnetfeldsensorelemente 14 einzustellen, während das Magnetfeld, das von dem Strom $I_m$ erzeugt wird, die zu messende Größe darstellt, die von der Mehrzahl von Magnetfeldsensorelementen 14 gemessen werden kann. In dem Ausführungsbeispiel 100 umfasst die Magnetfelderzeugungseinrichtung 20 über sechs kreisringförmig gebogene permanentmagnetische Magnetelemente 24, die aneinanderstoßen, und die einen umgebenden Kreisring erzeugen, der die geschlossene Kurve von Magnetfeldsensorelementen umfasst. Jedem permanentmagnetischen Magnetelement 24 der Magnetfelderzeugungseinrichtung 20 sind zwei Magnetfeldsensorelemente 14 zugeordnet. Eine nicht dargestellte Auswerteeinrichtung erfasst alle Ausgangsgrößen der Magnetfeldsensorelemente 14, und kann durch Summation der erfassten Magnetfelder des stromdurchflossenen Leiters den Gesamtstrom $I_m$ bestimmen.

In der Fig. 2 ist ein weiteres Ausführungsbeispiel 102 einer Magnetfeldsensorvorrichtung 10 dargestellt. Im Gegensatz zum in Fig. 1 dargestellten Ausführungsbeispiel 100 ist in dem vorliegenden Ausführungsbeispiel 102 die Ausrichtung des magnetischen Hilfsfelds 22 der aneinanderstoßenden Magnetelemente 24 gegensinnig, so dass zwei benachbarte Magnetelemente 24 in entgegengesetzter Richtung magnetisiert sind. Jedem Magnetelement 24 ist ein Magnetfeldsensorelement 14 zugeordnet. Durch die gegensinnige Orientierung ziehen sich benachbarte Magnetelemente 24 gegenseitig magnetisch an, so dass der Ring aus Magnetelementen 24, der sich zur Magnetfelderzeugungseinrichtung 20 zusammensetzt, mechanisch selbststabilisierend ist, und die einzelnen Magnetelemente 24 aneinander haften. Hierdurch wird die mechanische Stabilität erhöht und insbesondere bei Vorsehen eines auftrennbaren Bereichs an der Stoßstelle zweier benachbarter Magnetelemente 24 eine selbstschließende Wirkung erreicht. Jedem Magnetelement 24 ist ein Magnetfeldsensorelement 14 zugeordnet, so dass benachbarte Magnetfeldsensorelemente 14 auf der Kreiskurve 16 entgegengesetzt magnetisierte Hilfsmagnetfelder 22 in radialer Richtung ausgesetzt sind. Optional kann jedem Magnetelement 24 auch eine Mehrzahl von Sensorelementen 14 zugeordnet sein.

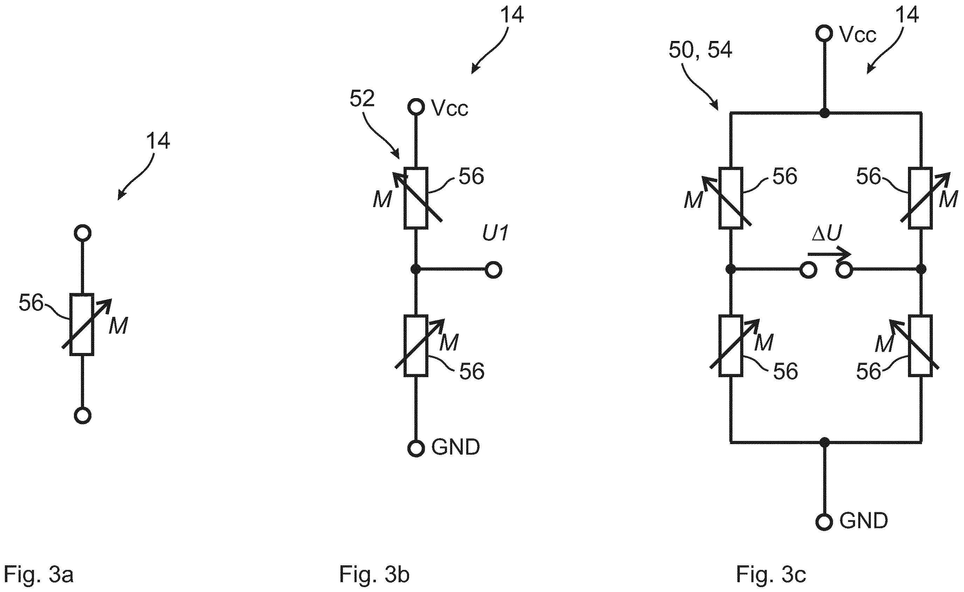

In den Fig. 3a, 3b und 3c sind Ersatzschaltbilder von Magnetfeldsensorelementen 14 dargestellt. Die Magnetfeldsensorelemente 14 können als einzelner magnetoresistiver Widerstand 56 mit einer Messempfindlichkeit in einer tangentialen Richtung zur Kurve 16 ausgelegt sein, wobei die Empfindlichkeitsrichtung $M$ von der Magnetisierungsrichtung des magnetischen Hilfsfeldes 22 bestimmt wird.

Auch können die Magnetfeldsensorelemente 14 als Halbbrücke, wie in Fig. 3b dargestellt, ausgelegt sein. In einer Halbbrücke sind mindestens zwei gegensinnig orientierte magnetoresistive Brückenwiderstände 56 verschaltet, und es existiert ein Mittelabgriff $U1$, so dass zumindest drei Anschlüsse am Magnetfeldsensorelement 14 nach außen sichtbar sind. Schließlich können die Magnetfeldsensorelemente 14 bevorzugterweise in Form einer Vollbrücke, wie in Fig. 3c dargestellt, ausgelegt sein. Sie bilden somit eine Wheatstone-Brückenschaltung 50, mit einer magnetoresistiven Vollbrücke 54, in denen zumindest vier magnetoresistive Brückenwiderstände 56 eingeschaltet sind. Jeweils sich kreuzweise gegenüberliegende magnetoresistive Brückenwiderstände 56 weisen die gleiche Empfindlichkeitsrichtung auf, wobei in jeder Halbbrücke 52 gegensinnig orientierte magnetoresistive Widerstände 56 verschaltet sind. Es existieren zwei Anschlüsse Vcc und GND für die Versorgungsspannung sowie zwei Abgriffe für eine Differenzspannung $\Delta U$ zwischen den beiden Halbbrücken, aus denen die Stärke eines tangentialen Magnetfelds, das von dem stromführenden Leiter 12 erzeugt wird, abgelesen werden kann. Sensitivität, und Vorzeichen der Differenzspannung $\Delta U$ kann von der Größe und Gestaltung des magnetischen Hilfsfeldes 22 abhängen.

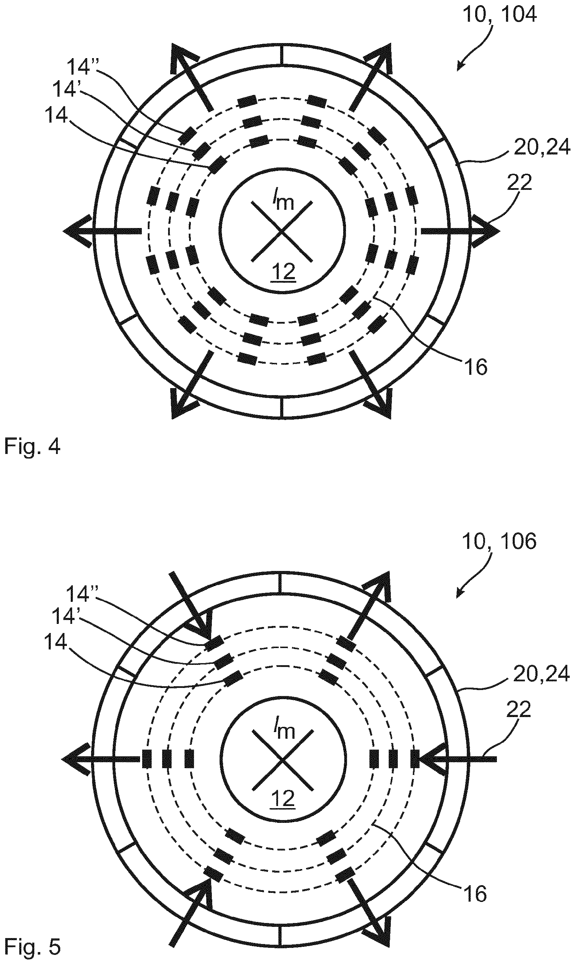

In den Fig. 4 und 5 sind weitere schematische Ausführungsbeispiele 104 bzw. 106 von Magnetfeldsensorvorrichtungen dargestellt. Die Fig. 4 ist eine Weiterentwicklung der in Fig. 1 dargestellten Ausführungsform 100, während die Ausführungsform 106 nach Fig. 5 eine vorteilhafte Weiterentwicklung der Ausführungsform 102 nach Fig. 2 darstellt.

In der Fig. 4 erzeugt die Magnetfelderzeugungseinrichtung 20 ein radial nach außen gerichtetes magnetisches Hilfsfeld 22, das von allen Magnetfeldsensorelementen 14 gesehen wird.

In der Fig. 5 ist das magnetische Hilfsfeld benachbarter permanentmagnetischer Magnetelemente 24 entgegengesetzt gerichtet, so dass jeweils drei Sätze von Magnetfeldsensorelementen ein radial nach innen gerichtetes magnetisches Hilfsfeld 22 sehen und drei Sätze von magnetischen Sensorelementen 14 ein Hilfsmagnetfeld 22 sehen, das radial nach außen gerichtet ist. In beiden Ausführungsformen 104, 106 sind drei konzentrisch angeordnete, geschlossene Ringe von Magnetfeldsensorelementen 14 auf geschlossenen Kurvenverläufen 16 vorgesehen, wobei eine radial am Innersten liegender Satz von Sensorelementen 14 eine radial etwas weiter außen liegende Satz 14' und eine radial noch weiter außen liegende Satz 14" von Magnetfeldelementen 14 angeordnet sind, die getrennt voneinander ausgewertet werden können und bei unterschiedlich hohen Strömen $I_M$ des stromführenden Leiters 12 ausgewertet werden können, um eine Messbereichsumschaltung zur Messung verschieden hoher Ströme $I_M$ bereitstellen zu können.

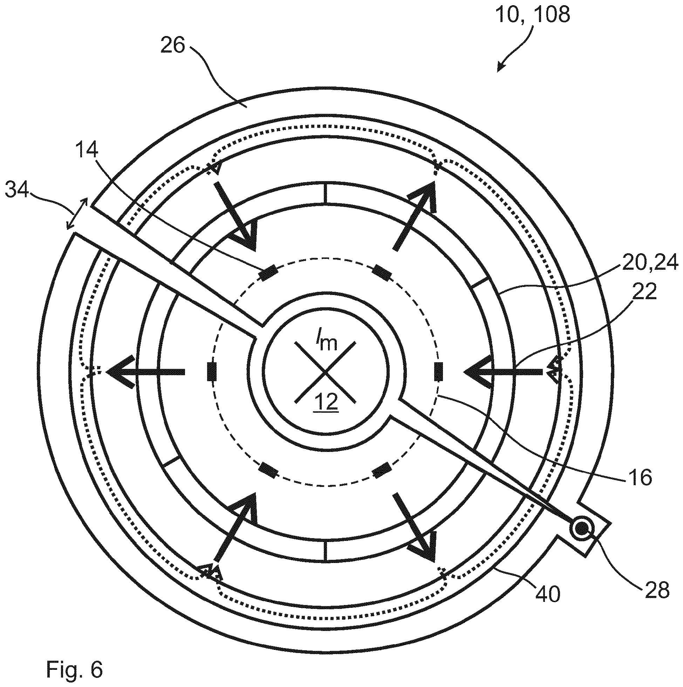

In der Fig. 6 ist eine Ausführungsform 108 einer Magnetfeldsensorvorrichtung 10 dargestellt, die in ihrem Grundaufbau der in Fig. 2 dargestellten Ausführungsform 102 ähnelt. Die Magnetfelderzeugungseinrichtung 20 umfassend ist eine magnetische Abschirmung 40, beispielsweise ein ferromagnetischer Ring, vorgesehen, die die Hilfslinien des magnetischen Hilfsfeldes 22 aufnimmt und führt, so dass ein geführter Rückschluss der magnetischen Hilfsfeldlinien 22 in der Ebene der Magnetfeldsensorvorrichtung erreicht werden kann. Das benachbart gegensinnig orientierte magnetische Hilfsfeld 22 durchsetzt Magnetfeldsensorelemente 14 auf einer geschlossenen kreisförmigen Kurve 16. Als Besonderheit ist die Ausführungsform 108 mit einem auftrennbaren Kurvenabschnitt 34 versehen, wobei die Gesamtanordnung auf einer Trägerringscheibe 26 angeordnet ist, und durch ein Drehgelenk 28 an einem radial äußersten Punkt der Magnetfeldsensorvorrichtung aufgeklappt werden kann. Durch den auftrennbaren Kurvenabschnitt 34, der an der Stoßstelle zweier gegensinnig magnetisch orientierter Magnetfeldelemente 24 verläuft, kann der stromführende Leiter $I_M$ 12 ein- und ausgeführt werden, so dass insbesondere bei der Anwendung in einer Strommesszange 60 eine selbstschließende Wirkung der Magnetfeldsensorvorrichtung 10 durch die Anziehung der gegensinnig orientierten magnetischen Magnetelemente 24 der Magnetfelderzeugungseinrichtung 20 erreicht werden kann.

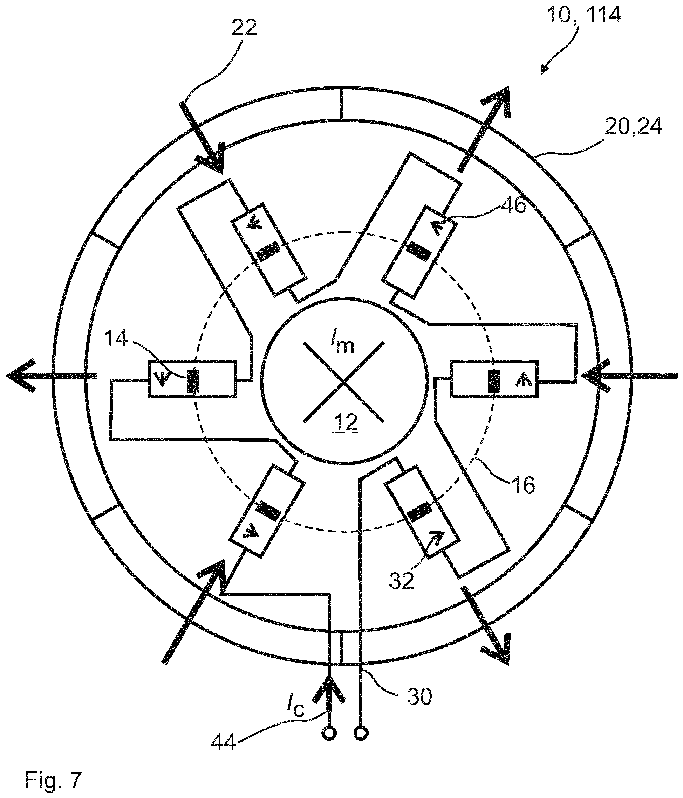

In der Fig. 7 ist ein weiteres Ausführungsbeispiel 114 einer Magnetfeldsensorvorrichtung 10 dargestellt, die dem Ausführungsbeispiel 102 nach Fig. 2 grundsätzlich ähnelt. Die Magnetfelderzeugungseinrichtung 20 umfasst sechs gegensinnig magnetisierte Permanentmagnetelemente 24, die in einem geschlossenen Ring aneinanderstoßen, wobei jedem Magnetelement ein Magnetfeldsensorelement 14 zugeordnet ist. Die Magnetfeldsensorelemente 14 sind auf einer kreisringförmigen Kurve 16 um einen Leiter 12 mit einem zu messenden Strom $I_M$ angeordnet. Zusätzlich zum Hilfsmagnetfeld 22, das jedes Magnetfeldsensorelement 14 durchsetzt, ist eine Kompensationsmagnetfelderzeugungseinrichtung 30 vorgesehen, durch den ein Kompensationsstrom $I_C$ 44 fließen kann. Hierdurch kann im Bereich jedes Magnetfeldsensorelements 14 ein Kompensationsmagnetfeld in tangentialer Richtung zur Kurve 16 erzeugt werden, das der Richtung des durch den Strom $I_M$ erzeugten Magnetfelds gegensinnig überlagert ist und dieses Magnetfeld kompensieren kann. Hierzu ist jedem Magnetfeldsensorelement 14 ein Kompensationsmagnetfeldleiter 46 in Form eines Leiterstreifens zugeordnet, der einen in radialer Richtung ausgerichteten Kompensationsstrom $I_C$ 44 trägt und entsprechend ein tangential zur Kurve 16 ausgerichtetes Kompensationsmagnetfeld 32 erzeugt. Durch das Kompensationsmagnetfeld 32 kann die Stärke des Magnetfelds des Leiters 12 herabgesetzt werden, und somit das zu messende Magnetfeld in einen Bereich gebracht werden, in dem eine besonders hohe Genauigkeit der Magnetfeldmessung ermöglicht wird. Hierdurch lassen sich beliebig große oder kleine Magnetfelder des stromführenden Leiters 12 messen. Das Kompensationsmagnetfeld 32 kann somit bei hohen Strömen $I_M$ entgegengesetzt zu dem Magnetfeld des Stroms gerichtet sein, um ein Differenzmagnetfeld zu erzeugen, und somit einen optimalen Messbereich der Magnetfeldsensorelemente 14 bereitstellen zu können. Hierdurch können betragsmäßig praktisch beliebig große Ströme gemessen werden. Des Weiteren können zeitlich variierende Ströme mit gleicher Genauigkeit gemessen werden, da z.B. wie in einer PLL-Schaltung ein Kompensationsmagnetfeld nachgeführt werden kann, um jede Stromamplitudenbereich gleich gut auflösen zu können. Hierdurch ist es weiterhin möglich, Gleich- oder Wechselspannungsanteile eines Stromflusses bzw. eines vom Stromleiter erzeugten Magnetfeldes mit hoher Genauigkeit zu analysieren, wodurch eine Analyse der Strommessung in DC- und AC-Anteile zugänglich wird, und alle Stromsignalanteile mit höchstmöglicher Genauigkeit erfasst werden können. Das Hilfsmagnetfeld 22 unterstützt insbesondere bei AMR- oder GMR-Mehrschichtwiderständen in den Magnetfeldsensorelementen 14 die Sensitivität der Messvorrichtung.

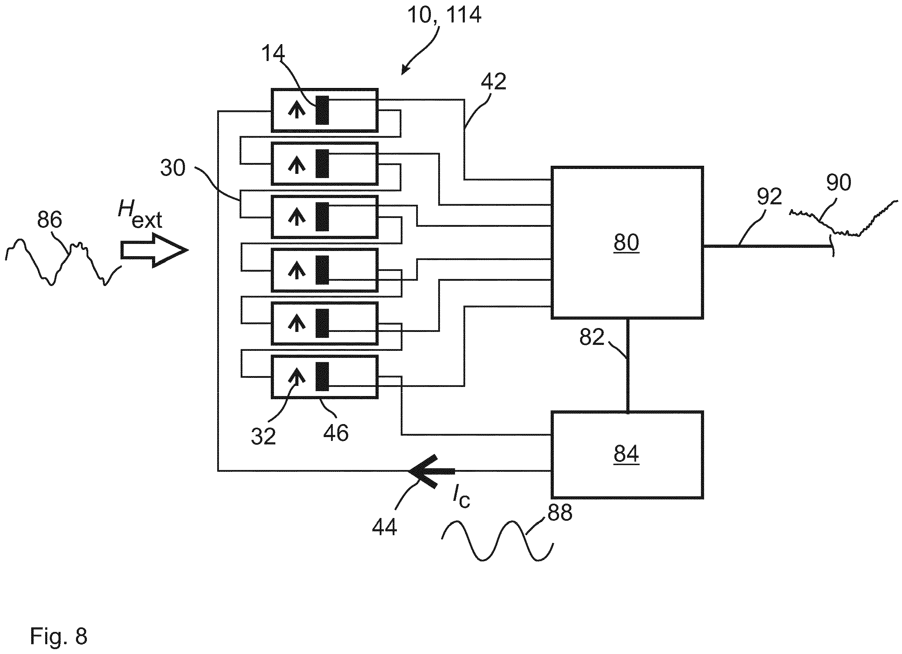

In der Fig. 8 ist in einem schematischen Blockschaltbild eine Erzeugung eines Kompensationsstroms $I_c$ 44 für eine Kompensationsmagnetfelderzeugungseinrichtung 30 mittels einer Störsignalextraktionseinheit 80 und einer Kompensationsstromerzeugungseinheit 84 dargestellt. Die Kompensationsmagnetfelderzeugungseinrichtung 30 kann beispielsweise der in der in Fig. 7 dargestellten Ausführungsform 114 entsprechen und umfasst für jedes Magnetfeldsensorelement 14 einen Kompensationsmagnetfeldleiter 46. Die Kompensationsmagnetfeldleiter 46 aller Sensorelemente 14 sind in Reihe angeschlossen und erzeugen beim Durchfluss des Kompensationsstroms $I_c$ 44 ein gleichartiges lokales Kompensationsmagnetfeld 32 am Ort jedes Magnetfeldsensorelements 14. Alternativ kann jeder Kompensationsmagnetfeldleiter 46 durch die Kompensationsstromerzeugungseinheit 84 mit einem individuell einstellbaren Kompensationsstroms $I_c$ 44 bestromt werden, so dass das Kompensationsmagnetfeld 32 jedes Magnetfeldsensorelements 14 individuell einstellbar ist.

Die Anordnung der Magnetfeldsensorelemente 14 ist in Fig. 8 zur besseren Übersicht linear dargestellt, wobei die Anordnung in der Regel entsprechend der Erfindung entlang einer geschlossenen Kurve um einen (nicht dargestellten) Leiter erfolgt.

Auf die Magnetfeldsensorelemente 14 wirkt ein magnetisches Feld $H_{ext}$ 86 mit einem skizzierten Amplitudenverlauf gleichermaßen ein, das von einem zu messenden Strom durch einen Leiter verursacht, und ggf. auch externe Magnetfeldkomponenten beinhalten kann. Im dargestellten Fall setzt sich das magnetische Feld $H_{ext}$ 86 aus einer AC Störkomponente 88 und einer Auswertesignalkomponente 90 zusammen, deren Amplitudenverlauf ebenfalls skizzenhaft angedeutet ist.

Jedes Magnetfeldsensorelement 14 erzeugt ein Sensorsignal, dass über eine Sensorsignalleitung 42 einer Störsignalextraktionseinheit 80 zugeführt wird. Die Störsignalextraktionseinheit 80 kann beispielsweise einen Gleichstromanteil (DC-Anteil) oder Wechselstromanteil (AC-Anteil) aus dem Sensor-Summensignal oder der Vielzahl von Sensorsignalen als Störsignal 88 extrahieren. Des Weiteren können externe Störgrößen wie Magnetfelder benachbarter technischer Einrichtungen, die auf jedes Sensorelement 14 eine gleiche oder unterschiedliche Wirkung haben, extrahiert werden. Die Störsignale 88 können mittels signaltheoretischer Verfahren wie z.B. Filterung, Signalverarbeitung oder einer Closed-Loop Steuerung wie beispielsweise einer PLL-Regelung extrahiert werden. Die Sensorsignale werden abzüglich der extrahierten Störsignale 88 als Auswertesignal 90 bzw. als mehrere Auswertesignale zur weiteren Bearbeitung über eine Signaldatenleitung 92 zur weiteren Verarbeitung, Speicherung oder Anzeige zur Verfügung gestellt werden. Bei Bedarf kann eine A/D-Wandlung der Signale in der Störsignalextraktionseinheit 80 oder in der Signalauswerteeinheit 82 erfolgen.

Das bzw. die extrahierten Störsignale 88 werden über eine Störsignaldatenleitung 82 einer Kompensationsstromerzeugungseinheit 84 zugeführt, die entsprechend des bzw. der Störsignale 88 einen entsprechenden Kompensationsstrom $I_c$ 44 oder individuell einstellbare Kompensationsströme 44 erzeugt. Der bzw. die Kompensationsströme $I_c$ 44 werden den Kompensationsmagnetfeldleitern 46 zugeführt und erzeugen lokale Kompensationsmagnetfelder 32, die die Störsignale 88 verursachende Signalanteile aus dem Magnetfeld $H_{ext}$ 86 an jedem Magnetfeldsensorelement 14 lokal kompensieren können. Somit ist ein Regelkreis zur Kompensation von Störmagnetfeldern 88, insbesondere AC- oder DC-Störsignale 88, geschaffen, die zum einen einer Übersteuerung des Messbereichs der Magnetfeldsensorelemente 14 entgegenwirken, andererseits lokale Ungleichheiten der Sensorsignale ausgleichen und externe Störmagnetfelder kompensieren können.

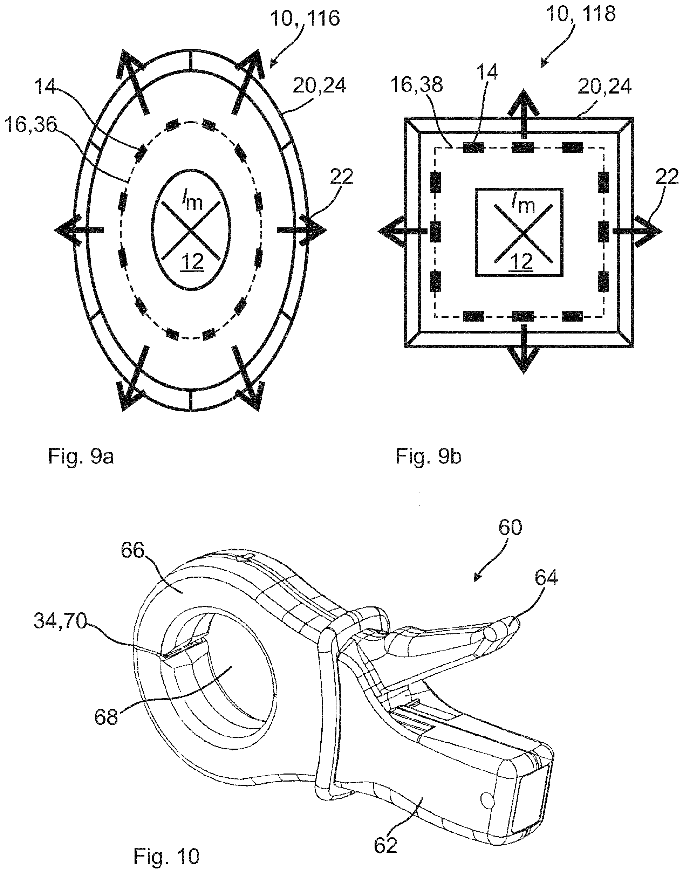

In den Fig. 9a und 9b sind entsprechend der Ausführungsform 100 der Fig. 1 weitere Ausführungsformen 116 und 118 von Magnetfeldsensorelementen dargestellt, bei denen der Kurvenverlauf 16 der Magnetfeldsensorelemente und damit der entsprechende Kurvenverlauf der Magnetfelderzeugungseinrichtung 20 elliptisch, wie in Fig. 9a dargestellt, oder rechteckförmig bzw. quadratisch, wie in Fig. 9b dargestellt, ausgeführt ist. Derartige elliptische oder rechteckförmige Kurvenverläufe 16 können bei entsprechenden Querschnitten der strömführenden Leiter 12 angepasst werden, um die Genauigkeit der Magnetfeldmessung und ein möglichst homogenes Magnetfeld entlang der Kurve 16 abgreifen zu können.

Schließlich ist in der Fig. 10 ein Ausführungsbeispiel einer Strommesszange 60 dargestellt, in der eine erfindungsgemäße Magnetfeldsensorvorrichtung 10 eingesetzt werden kann. Die Strommesszange 60 umfasst einen Griff 62 und einen Öffnungshebel 64, mit denen der Öffnungsbereich 70 geöffnet werden kann, wobei ein auftrennbarer Kurvenabschnitt 34 der eingesetzten Magnetfeldsensorvorrichtung 66 geöffnet wird, um einen stromführenden Leiter 12 in die Öffnung 68 der Strommesszange 60 einzuführen. Mittels der Strommesszange 60 kann berührungslos der Strom durch ein Kabel bzw. einen einzelnen Leiter gemessen werden, ohne den Stromfluss zu unterbrechen, wobei durch Messung der den Leiter umgebenden Magnetfelder eine exakte Strommessung erreicht werden kann. In der Messzange 60 kann eine Auswerteeinheit vorgesehen sein, die die Ausgangssignale der Magnetfeldsensorelemente 14 auswertet und den Gesamtstrom durch den Leiter auswerten kann.

Bezugszeichenliste

| | |
|---|---|
| 10 | Magnetfeldsensorvorrichtung |
| 12 | stromführender Leiter |
| 14 | Magnetfeldsensorelement |
| 16 | Kurve der Magnetfeldsensorelemente |
| 20 | Magnetfelderzeugungseinrichtung |
| 22 | magnetisches Hilfsfeld |
| 24 | permanentmagnetisches Magnetelement |
| 26 | Trägerringscheibe |
| 28 | Drehgelenk |
| 30 | Kompensationsmagnetfelderzeugungseinrichtung |
| 32 | Kompensationsmagnetfeld |
| 34 | auftrennbarer Kurvenabschnitt |
| 36 | elliptischer Kurvenverlauf |
| 38 | rechteckiger Kurvenverlauf |
| 40 | magnetische Abschirmung |
| 42 | Sensorsignalleitung |
| 44 | Kompensationsstrom $I_\mathrm{C}$ |
| 46 | Kompensationsmagnetfeldleiter eines Magnetfeldsensorelements |
| 50 | Wheatstone-Brückenschaltung |
| 52 | Magnetoresistive Halbbrücke |
| 54 | Magnetoresistive Vollbrücke |
| 56 | Magnetoresistiver Brückenwiderstand |
| 58 | Ohmscher Brückenwiderstand |
| 60 | Strommesszange |
| 62 | Griff |
| 64 | Öffnungshebel |
| 66 | Magnetfeldsensorvorrichtung |
| 68 | Öffnung für stromführenden Leiter |
| 70 | Öffnungsbereich |
| 80 | Störsignalextraktionseinheit |
| 82 | Störsignaldatenleitung |
| 84 | Kompensationsstromerzeugungseinheit |
| 86 | Magnetisches Feld |
| 88 | Störsignal |
| 90 | Auswertesignal |
| 92 | Signaldatenleitung |
| 100 | Magnetfeldsensorvorrichtung mit gleichsinnigem Hilfsmagnetfeld |
| 102 | Magnetfeldsensorvorrichtung mit gegensinnigem Hilfsmagnetfeld |
| 104 | Magnetfeldsensorvorrichtung mit konzentrischer Anordnung und gleichsinniges Magnetfeld |
| 106 | Magnetfeldsensorvorrichtung mit konzentrischer Anordnung und gegensinnigem Magnetfeld |
| 108 | Magnetfeldsensorvorrichtung mit Abschirmung |
| 114 | Magnetfeldsensorvorrichtung mit Flipleiter |
| 116 | Magnetfeldsensorvorrichtung mit elliptischer Anordnung |
| 118 | Magnetfeldsensorvorrichtung mit rechteckförmiger Anordnung |

**Patentansprüche**

1. Magnetfeldsensorvorrichtung (10, 66, 100, 102, 104, 106, 108, 114, 116, 118) zur Messung des Stromes durch zumindest einen stromführenden Leiter (12), umfassend eine Mehrzahl entlang einer geschlossenen, bevorzugt kreisförmigen, rechteckigen oder elliptischen Kurve (16) um den Leiter (12) angeordneter Magnetfeldsensorelemente (14), die eine magnetfeldsensitive Vorzugsrichtung im Wesentlichen tangential bzw. parallel zur Kurve (16) aufweisen, und eine Magnetfelderzeugungseinrichtung (20), wobei die Magnetfelderzeugungseinrichtung (20) mehrere permanentmagnetische, dem Kurvenverlauf folgende Magnetelemente (24) umfasst, die ein magnetisches Hilfsfeld (22) am Ort der Magnetfeldsensorelemente (14) erzeugen, das im Wesentlichen rechtwinklig zum Verlauf der Kurve (16) der Magnetfeldsensorelement (14) ausgerichtet ist, **dadurch gekennzeichnet, dass** die Magnetelemente aneinanderstoßend sind und magnetisch entgegengesetzt ausgerichtet sind.

2. Vorrichtung (10, 66, 100, 102, 104, 106, 108, 114, 116, 118) nach Anspruch 1, **dadurch gekennzeichnet, dass** die Magnetfelderzeugungseinrichtung (20) eingerichtet ist, eine Magnetfeldkomponente des rechtwinklig zum Verlauf der Kurve (16) ausgerichteten Hilfsfeldes (22), das am Ort einer ersten Teilmenge von Magnetfeldsensorelementen (14) wirkt, relativ zum Leiter (12) entgegengesetzt zu einer Magnetfeldkomponente des Hilfsfeldes (22) auszurichten, das am Ort einer zweiten Teilmenge von Magnetfeldsensorelementen (14) relativ zum Leiter (12) wirkt, wobei bevorzugt die Anzahl der Magnetfeldsensorelemente (14) jeder Teilmenge, identisch ist.

3. Vorrichtung (10, 66, 100, 102, 104, 106, 108, 114, 116, 118) nach einem der vorhergehenden Ansprüche, **dadurch gekennzeichnet, dass** jedem Magnetelement (24) ein oder mehrere Magnetfeldsensorelemente (14) zugeordnet sind.

4. Vorrichtung (10, 66, 100, 102, 104, 106, 108, 114, 116, 118) nach einem der vorhergehenden Ansprüche, **dadurch gekennzeichnet, dass** eine Kompensationsmagnetfelderzeugungseinrichtung (30) umfasst ist, die ein magnetisches Kompensationsmagnetfeld (32) am Ort jedes Magnetfeldsensorelements (14) im Wesentlichen in einer magnetfeldsensitiven Ebene des Magnetfeldsensorelements (14) parallel und bevorzugt entgegengesetzt zu einer Magnetfeldkomponente des zu messenden stromführenden Leiters (12) erzeugen kann.

5. Vorrichtung (10, 66, 100, 102, 104, 106, 108, 114, 116, 118) nach Anspruch 4, **dadurch gekennzeichnet, dass** das magnetische Kompensationsmagnetfeld (32) jedes Magnetfeldsensorelements (14) individuell einstellbar ist.

6. Vorrichtung (10, 66, 100, 102, 104, 106, 108, 114, 116, 118) nach Anspruch 4 oder 5, **dadurch gekennzeichnet, dass** eine Störsignalextraktionseinheit (80) und eine Kompensationsstromerzeugungseinheit (84) umfasst sind, wobei die Störsignalextraktionseinheit (80) aus zumindest einem Sensorsignal eines Magnetfeldsensorelements (14), insbesondere aus Sensorsignalen einer Mehrzahl von Magnetfeldsensorelementen (14) ein oder mehrere Störsignale (88) extrahieren kann, und die Kompensationsstromerzeugungseinheit (84) entsprechend dem extrahierten Störsignal (88) zumindest einen Kompensationsstrom (44) zur Erzeugung eines Kompensationsmagnetfelds (32) erzeugt.

7. Vorrichtung (10, 66, 100, 102, 104, 106, 108, 114, 116, 118) nach einem der vorhergehenden Ansprüche, **dadurch gekennzeichnet, dass** zumindest zwei, bevorzugt formgleiche Kurvenanordnungen (16) von Magnetfeldsensorelementen (14) den stromführenden Leiter (12) in unterschiedlichen radialen Abständen umschließen.

8. Vorrichtung (10, 66, 100, 102, 104, 106, 108, 114, 116, 118) nach einem der vorhergehenden Ansprüche, **dadurch gekennzeichnet, dass** die Magnetfeldsensorelemente (14) AMR-Magnetfeldsensorelemente oder GMR-Multilayer-Magnetfeldsensorelemente sind.

9. Vorrichtung (10, 66, 100, 102, 104, 106, 108, 114, 116, 118) nach einem der vorhergehenden Ansprüche, **dadurch gekennzeichnet, dass** die Magnetfelderzeugungseinrichtung (20) von einer magnetischen Abschirmung (40) umgeben ist.

10. Vorrichtung (10, 66, 100, 102, 104, 106, 108, 114, 116, 118) nach einem der vorhergehenden Ansprüche, **dadurch gekennzeichnet, dass** die Anordnung der Magnetfeldsensorelemente (14) und der Magnetfelderzeugungseinrichtung (20) einen auftrennbaren Kurvenabschnitt (34) zur Ein- und Ausführung des stromführenden Leiters (12) umfasst.

11. Vorrichtung (10, 66, 100, 102, 104, 106, 108, 114, 116, 118) nach einem der vorhergehenden Ansprüche, **dadurch gekennzeichnet, dass** jedes Magnetfeldsensorelement (14) eine Halbbrücke (52) oder eine Vollbrücke (54) einer magnetoresistiven Wheatstone-Brückenschaltung (50) umfasst.

12. Vorrichtung (10, 66, 100, 102, 104, 106, 108, 114, 116, 118) nach einem der vorhergehenden Ansprüche, **dadurch gekennzeichnet, dass** die Sensorausgangssignale aller Magnetfeldsensorelemente (14) gegenüber einem von dem stromführenden Leiter (12) erzeugten Magnetfeld gleichgerichtete Signalwertveränderungen aufweisen, so dass ein erhöhter Stromfluss durch den Leiter (12) eine Erhöhung der Widerstandswerte oder der Ausgangssignale aller Magnetfeldsensorelemente (14) bewirkt.

13. Vorrichtung (10, 66, 100, 102, 104, 106, 108, 114, 116, 118) nach Anspruch 12, **dadurch gekennzeichnet, dass** die Sensorausgangssignale aller Magnetfeldsensorelemente (14) zur Bestimmung eines Stroms des stromführenden Leiters (12) gewichtet, insbesondere gemittelt werden.

14. Strommesszange (60) umfassend eine Magnetfeldsensorvorrichtung (10, 66, 100, 102, 104, 106, 108, 114, 116, 118) nach einem der vorhergehenden Ansprüche.

**Claims**

1. Magnetic field sensing device (10, 66, 100, 102, 104, 106, 108, 114, 116, 118) for measuring the current through at least one current-carrying conductor (12), comprising a plurality of magnetic field sensing elements (14) arranged along a closed and preferably circular, rectangular or elliptic curve (16) around said conductor (12) and which have a magnetic-field-sensitive preferential direction substantially tangential or parallel to said curve (16), and a magnetic field generating device (20), where said magnetic field generating device (20) comprises several permanently magnetic elements (24) following the line of the curve and generating at the location of the magnetic field sensing elements (14) a magnetic auxiliary field (22) which is aligned substantially at right angles to the line of the curve (16) of the magnetic field sensing elements (14), **characterized in that** the magnetic elements are abutting and are aligned magnetically opposed.

2. Device (10, 66, 100, 102, 104, 106, 108, 114, 116, 118) according to claim 1, **characterized in that** the magnetic field generating device (20) is designed to align a magnetic field component of the auxiliary field (22) aligned at right angles to the line of the curve (16) and which acts at the location of a first subset of magnetic field sensing elements (14), relative to the conductor (12) opposed to a magnetic field component of said auxiliary field (22) which acts at the location of a second subset of magnetic field sensing elements (14) relative to the conductor, where the number of magnetic field sensing elements (14) of each subset is preferably identical.

3. Device (10, 66, 100, 102, 104, 106, 108, 114, 116, 118) according to one of the preceding claims, **characterized in that** each magnetic element (24) is assigned one or more magnetic field sensing elements (14).

4. Device (10, 66, 100, 102, 104, 106, 108, 114, 116, 118) according to one of the preceding claims, **characterized in that** a compensating magnetic field generating device (30) is comprised which can generate a magnetic compensating magnetic field (32) at the location of each magnetic field sensing element (14) substantially in a magnetic-field-sensitive plane of said magnetic field sensing element (14) parallel and preferably opposed to a magnetic field component of the current-carrying conductor (12) to be measured.

5. Device (10, 66, 100, 102, 104, 106, 108, 114, 116, 118) according to claim 4, **characterized in that** the magnetic compensating magnetic field (32) of each magnetic field sensing element (14) is individually adjustable.

6. Device (10, 66, 100, 102, 104, 106, 108, 114, 116, 118) according to claim 4 or 5, **characterized in that** an interfering signal extraction unit (80) and a compensating current generating unit (84) are comprised, where said interfering signal extraction unit (80) can extract one or more interfering signals (88) from at least one sensor signal of a magnetic field sensing element (14), in particular from sensor signals of a plurality of magnetic field sensing elements (14), and said compensating current generating unit (84) generates corresponding to the extracted interfering signal (88) at least one compensating current (44) for generating a compensating magnetic field (32).

7. Device (10, 66, 100, 102, 104, 106, 108, 114, 116, 118) according to one of the preceding claims, **characterized in that** at least two preferably identically shaped curve arrangements (16) of magnetic field sensing elements (14) enclose the current-carrying conductor (12) at differing radial intervals.

8. Device (10, 66, 100, 102, 104, 106, 108, 114, 116, 118) according to one of the preceding claims, **characterized in that** the magnetic field sensing elements (14) are AMR magnetic field sensing elements or GMR multilayer magnetic field sensing elements.

9. Device (10, 66, 100, 102, 104, 106, 108, 114, 116, 118) according to one of the preceding claims, **characterized in that** the magnetic field generating device (20) is surrounded by magnetic shielding (40).

10. Device (10, 66, 100, 102, 104, 106, 108, 114, 116, 118) according to one of the preceding claims, **characterized in that** the arrangement of the magnetic field sensing elements (14) and of the magnetic field generating device (20) comprises an openable curve section (34) for insertion and extraction of the current-carrying conductor (12).

11. Device (10, 66, 100, 102, 104, 106, 108, 114, 116, 118) according to one of the preceding claims, **characterized in that** each magnetic field sensing element (14) comprises a half bridge (52) or a full bridge (54) of a magnetoresistive Wheatstone bridge circuit (50).

12. Device (10, 66, 100, 102, 104, 106, 108, 114, 116, 118) according to one of the preceding claims, **characterized in that** the sensor output signals of all magnetic field sensing elements (14) exhibit rectified signal value changes relative to a magnetic field generated by the current-carrying conductor (12), so that an increased current flow through said conductor (12) effects an increase in the resistance values or the output signals of all magnetic field sensing elements (14).

13. Device (10, 66, 100, 102, 104, 106, 108, 114, 116, 118) according to claim 12, **characterized in that** the sensor output signals of all magnetic field sensing elements (14) are weighted, in particular averaged, for determining a current of the current-carrying conductor (12).

14. Clamp-on current probe (60) comprising a magnetic field sensing device (10, 66, 100, 102, 104, 106, 108, 114, 116, 118) according to one of the preceding claims.

**Revendications**

1. Dispositif de détection de champ magnétique (10, 66, 100, 102, 104, 106, 108, 114, 116, 118) destiné à mesurer le courant traversant au moins un conducteur parcouru par un courant (12), comprenant une pluralité d'éléments de détection de champ magnétique (14) disposés autour du conducteur (12) le long d'une courbe (16) circulaire, rectangulaire ou elliptique, qui présentent une orientation préférée sensible au champ magnétique essentiellement tangentielle ou parallèle à la courbe (16), et un dispositif de production de champ magnétique (20), sachant que le dispositif de production de champ magnétique (20) comprend plusieurs éléments magnétiques (24) à aimantation permanente, suivant le tracé de la courbe, qui produisent un champ magnétique auxiliaire (22) sur l'emplacement des éléments de détection de champ magnétique (14), lequel champ magnétique auxiliaire est essentiellement positionné à angle droit du tracé de la courbe (16) des éléments de détection du champ magnétique (14), **caractérisé en ce que** les éléments magnétiques sont contigus et orientés dans des directions opposées magnétiquement.

2. Dispositif (10, 66, 100, 102, 104, 106, 108, 114, 116, 118) selon la revendication 1, **caractérisé en ce que** le dispositif de production de champ magnétique (20) est configuré pour orienter une composante du champ magnétique auxiliaire (22) positionné à angle droit du tracé de la courbe (16) par rapport au conducteur (12) et agissant à l'emplacement d'une première quantité partielle d'éléments de détection de champ magnétique (14), dans la direction opposée à une composante du champ magnétique auxiliaire (22) agissant à l'emplacement d'une seconde quantité partielle d'éléments de détection de champ magnétique (14) par rapport au conducteur (12), sachant que, de préférence, le nombre d'éléments de détection du champ magnétique (14) de chaque quantité partielle est identique.

3. Dispositif (10, 66, 100, 102, 104, 106, 108, 114, 116, 118) selon une des revendications précédentes, **caractérisé en ce qu'**un ou plusieurs éléments de détection du champ magnétique (14) sont associés à chaque élément magnétique (24)

4. Dispositif (10, 66, 100, 102, 104, 106, 108, 114, 116, 118) selon une des revendications précédentes, **caractérisé en ce qu'**est compris un dispositif de production de champ magnétique de compensation (30) qui peut produire un champ magnétique de compensation (32) à l'emplacement de chaque élément de détection du champ magnétique (14) essentiellement dans un plan sensible au champ magnétique de l'élément de détection du champ magnétique (14), parallèle et de préférence dans le sens opposé à une composante de champ magnétique du conducteur à mesurer, parcouru par un courant (12).

5. Dispositif (10, 66, 100, 102, 104, 106, 108, 114, 116, 118) selon la revendication 4, **caractérisé en ce que** le champ magnétique de compensation (32) de chaque élément de détection de champ magnétique (14) est réglable de manière individuelle.

6. Dispositif (10, 66, 100, 102, 104, 106, 108, 114, 116, 118) selon la revendication 4 ou 5, **caractérisé en ce que** sont comprises une unité d'extraction de signal parasite (80) et une unité de production de courant de compensation (84), sachant que l'unité d'extraction de signal parasite (80) peut extraire un ou plusieurs signaux parasites (88) d'au moins un signal de détection d'un élément de détection de champ magnétique (14), notamment de signaux de détection d'une pluralité d'éléments de détection de champ magnétique (14), et que l'unité de production de courant de compensation (84) produit, en fonction du signal parasite extrait (88), au moins un courant de compensation (44) pour produire un champ magnétique de compensation (32).

7. Dispositif (10, 66, 100, 102, 104, 106, 108, 114, 116, 118) selon une des revendications précédentes, **caractérisé en ce qu'**au moins deux dispositions de courbe (16), de préférence de forme identique des éléments de détection de champ magnétique (14) entourent le conducteur parcouru par un courant (12) à différentes distances radiales.

8. Dispositif (10, 66, 100, 102, 104, 106, 108, 114, 116, 118) selon une des revendications précédentes, **caractérisé en ce que** les éléments de détection du champ magnétique (14) sont des éléments de détection du champ magnétique AMR ou des éléments de détection du champ magnétique multicouches GMR.

9. Dispositif (10, 66, 100, 102, 104, 106, 108, 114, 116, 118) selon une des revendications précédentes, **caractérisé en ce que** le dispositif de production de champ magnétique (20) est entouré d'un blindage magnétique (40).

10. Dispositif (10, 66, 100, 102, 104, 106, 108, 114, 116, 118) selon une des revendications précédentes, **caractérisé en ce que** la disposition des éléments de détection de champ magnétique (14) et du dispositif de production de champ magnétique (20) comprend une section de courbe séparable (34) pour introduire et sortir le conducteur parcouru par un courant (12).

11. Dispositif (10, 66, 100, 102, 104, 106, 108, 114, 116, 118) selon une des revendications précédentes, **caractérisé en ce que** chaque élément de détection de champ magnétique (14) comprend un demi-pont (52) ou un pont complet (54) d'un circuit en pont de Wheatstone magnétorésistif (50).

12. Dispositif (10, 66, 100, 102, 104, 106, 108, 114, 116, 118) selon une des revendications précédentes, **caractérisé en ce que** les signaux de sortie de tous les éléments de détection de champ magnétique (14) présentent des changements de valeur de signal de même sens par rapport à un champ magnétique produit par le conducteur parcouru par un courant (12) si bien qu'un flux de courant élevé à travers le conducteur (12) provoque une hausse des valeurs de résistance ou des signaux de sortie de tous les éléments de détection du champ magnétique (14).

13. Dispositif (10, 66, 100, 102, 104, 106, 108, 114, 116, 118) selon la revendication 12, **caractérisé en ce**

**que** les signaux de sortie de tous les éléments de détection de champ magnétique (14) sont pondérés, notamment moyennés pour déterminer un courant du conducteur parcouru par un courant (12).

14. Pince ampèremétrique (60) comprenant un dispositif de détection de champ magnétique (10, 66, 100, 102, 104, 106, 108, 114, 116, 118) selon une des revendications précédentes.

10, 100

20,24

22

$I_m$

12

14

16

Fig. 1

10, 102

20,24

22

$I_m$

12

14

16

Fig. 2

Fig. 3c

Fig. 3b

Fig. 3a

17

10, 104

14"
14'
14

20,24

22

$I_m$

12

16

Fig. 4

10, 106

14"
14'
14

20,24

22

$I_m$

12

16

Fig. 5

Fig. 6

Fig. 7

Fig. 8

EP 3 248 019 B1

10, 116

14

16,36

20,24

22

/m

12

Fig. 9a

10, 118

16,38

14

20,24

22

/m

12

Fig. 9b

60

66

64

34,70

68

62

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010036040 A1
- DE 102008030334 A1
- US 20050156587 A
- DD 255214 A1
- JP 2011089931 A
- JP 2012150007 A
- WO 2010009761 A1